(19) Europäisches Patentamt
European Patent Office
Office européen des brevets

(11) **EP 3 509 214 B1**

(12) **FASCICULE DE BREVET EUROPEEN**

(45) Date de publication et mention
de la délivrance du brevet:
**18.11.2020 Bulletin 2020/47**

(21) Numéro de dépôt: **19150014.9**

(22) Date de dépôt: **02.01.2019**

(51) Int Cl.:
*H01J 49/26* *(2006.01)*    *H03H 9/02* *(2006.01)*
*H03H 9/24* *(2006.01)*    *G01H 9/00* *(2006.01)*
*G01D 5/26* *(2006.01)*    *G01H 11/08* *(2006.01)*

(54) **DISPOSITIF DE DETECTION MICRO OU NANOMECANIQUE DE PARTICULES**

MIKRO- ODER NANOMECHANISCHE VORRICHTUNG ZUR DETEKTION VON PARTIKELN

MICRO OR NANOMECHANICAL DEVICE FOR DETECTING PARTICLES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.01.2018 FR 1850025**

(43) Date de publication de la demande:
**10.07.2019 Bulletin 2019/28**

(73) Titulaire: **Commissariat à l'énergie atomique et aux énergies alternatives
75015 Paris (FR)**

(72) Inventeurs:
• **HENTZ, Sébastien**
  **38170 SEYSSINET-PARISET (FR)**
• **SANSA PERNA, Marc**
  **08211 CASTELAR DEL VALLES (ES)**

(74) Mandataire: **Brevalex
95, rue d'Amsterdam
75378 Paris Cedex 8 (FR)**

(56) Documents cités:
**EP-A1- 3 147 673**

• **AMIR RAHAFROOZ ET AL: "Fabrication and characterization of thermally actuated micromechanical resonators for airborne particle mass sensing: I. Resonator design and modeling;Fabrication and characterization of thermally actuated micromechanical resonators for airborne particle mass sensing: I", JOURNAL OF MICROMECHANICS & MICROENGINEERING, INSTITUTE OF PHYSICS PUBLISHING, BRISTOL, GB, vol. 20, no. 12, 18 novembre 2010 (2010-11-18), page 125018, XP020201641, ISSN: 0960-1317, DOI: 10.1088/0960-1317/20/12/125018**
• **ARASH HAJJAM ET AL: "Fabrication and characterization of thermally actuated micromechanical resonators for airborne particle mass sensing: II. Device fabrication and characterization;Fabrication and characterization of thermally actuated micromechanical resonators for airborne particle mass sensing: II", JOURNAL OF MICROMECHANICS & MICROENGINEERING, INSTITUTE OF PHYSICS PUBLISHING, BRISTOL, GB, vol. 20, no. 12, 18 novembre 2010 (2010-11-18), page 125019, XP020201642, ISSN: 0960-1317, DOI: 10.1088/0960-1317/20/12/125019**
• **ARASH HAJJAM ET AL: "Thermally actuated MEMS resonant sensors for mass measurement of micro/nanoscale aerosol particles", SENSORS, 2009 IEEE, IEEE, PISCATAWAY, NJ, USA, 25 octobre 2009 (2009-10-25), pages 707-710, XP031618965, ISBN: 978-1-4244-4548-6**

- SOYSAL U ET AL: "Aerosol mass concentration measurements: Recent advancements of real-time nano/micro systems", JOURNAL OF AEROSOL SCIENCE, vol. 114, 7 septembre 2017 (2017-09-07), pages 42-54, XP085242166, ISSN: 0021-8502, DOI: 10.1016/J.JAEROSCI.2017.09.008
- KHINE L ET AL: "High-Q bulk-mode SOI square resonators with straight-beam anchors", JOURNAL OF MICROMECHANICS & MICROENGINEERING, INSTITUTE OF PHYSICS PUBLISHING, BRISTOL, GB, vol. 19, no. 1, 1 janvier 2009 (2009-01-01), page 15017, XP020153289, ISSN: 0960-1317, DOI: 10.1088/0960-1317/19/1/015017
- ANGEL T-H LIN ET AL: "Electrostatically transduced face-shear mode silicon MEMS microresonator", FREQUENCY CONTROL SYMPOSIUM (FCS), 2010 IEEE INTERNATIONAL, IEEE, PISCATAWAY, NJ, USA, 1 juin 2010 (2010-06-01), pages 534-538, XP031738459, ISBN: 978-1-4244-6399-2

**Description**

## DOMAINE TECHNIQUE ET ÉTAT DE LA TECHNIQUE ANTÉRIEURE

La présente invention se rapporte à un dispositif de détection mécanique mettant en œuvre des structures micromécaniques et/ou nanomécaniques résonantes.

Le dispositif de détection peut être utilisé dans la détection gravimétrique et plus particulièrement dans les capteurs chimiques pour la détection de gaz, dans les capteurs biologiques et dans les spectromètres de masse à base de structures micromécaniques et/ou nanomécaniques résonantes.

Un spectromètre de masse est un détecteur de masse qui permet de déterminer la masse de particules individuelles. Il est par exemple utilisé en biologie pour déterminer la masse de cellules biologiques. Un système micro et/ou nanomécanique résonant peut être utilisé dans un spectromètre de masse. Le système comporte une poutre ou une structure apte à accueillir par exemple une cellule biologique, la poutre ou la structure est excitée à sa fréquence de résonance. Le dépôt d'une cellule biologique modifie la masse de la poutre ou de la structure et modifie donc sa fréquence de résonance. En mesurant et en traitant la variation de fréquence de résonance, correspondant au dépôt de chaque cellule biologique, on peut en déduire la masse de la cellule biologique.

Le document A. Rahafrooz and S. Pourkamali, "Fabrication and characterization of thermally actuated micromechanical resonators for airborne particle mass sensing: I. Resonator design and modeling," J. Micromechanics Microengineering, vol. 20, no. 12, p. 125018, 2010 décrit un résonateur micromécanique pour la détection de la masse de particules dans l'air. Ce résonateur comporte une plateforme suspendue à ses quatre sommets par quatre poutres. Deux de ces poutres sont actives, c'est à dire, elles sont dédiées à l'actuation et la détection du mouvement de la plateforme. Chaque poutre active est divisée en deux et est connectée à deux électrodes différentes, de façon qu'un courant puisse circuler à travers la poutre. L'actuation est obtenue en faisant circuler un courant modulé dans la poutre et la détection est obtenue en détectant le courant circulant à travers de la poutre du fait de l'effet piézorésistif. Suite à l'actuation, la masse est mise en vibration dans le plan. D'une part, ce dispositif comporte des poutres de forme complexe. En outre elles requièrent deux connexions électriques chacune, ce qui limite ses dimensions minimales atteignables pour le dispositif. La fabrication de ce dispositif est complexe. D'autre part, le fait de faire circuler du courant à travers la poutre provoque un échauffement de la structure et modifie ses propriétés. En outre, cet échauffement limite le choix des matériaux adaptés à la réalisation des poutres. De plus, cette structure n'est pas adaptée à une excitation et/ou une détection des modes hors-plan.

## EXPOSÉ DE L'INVENTION

C'est par conséquent un but de la présente invention d'offrir un dispositif de détection de particules présentant une structure simplifiée par rapport à celle des dispositifs de détection de particules de l'état de la technique.

Le but énoncé ci-dessus est atteint par un dispositif de détection de particules comportant une plateforme, dont une face au moins est destinée à recevoir la ou les particules à détecter, des moyens de suspension de la plateforme de sorte qu'elle puisse être mise en vibration, des moyens de mise en vibration de ladite plateforme, les moyens de suspension comportant au moins deux poutres, lesdites poutres étant configurées pour se déformer lorsque la plateforme est mise en vibration, les poutres et la plateforme étant dimensionnées pour que, lors de la mise en vibration de la plateforme, celle-ci ne soit pas ou peu déformée par l'action des poutres déformées. Le dispositif de détection comporte également des moyens de détection du déplacement de la plateforme.

Les poutres présentent une longueur entre le support et la plateforme au moins dix fois supérieure aux dimensions de la section des poutres. La dimension des poutres dans la direction du mouvement de vibration est au moins dix fois plus petite que la dimension de la plateforme dans cette direction.

Dans des exemples de réalisation de déplacements dans le plan et hors-plan de la plateforme, les poutres sont déformées en flexion.

Dans un exemple de réalisation, les moyens de détection mettent en œuvre les poutres des moyens de suspension qui sont par exemple en matériau piézorésistif.

Dans un autre exemple de réalisation, les moyens de détection sont optiques et comportent un résonateur optique disposé à proximité de la plateforme, de sorte que le déplacement de la plateforme modifie les propriétés optiques du résonateur.

La présente invention a alors pour objet un dispositif de détection de particules comportant un support et au moins une structure mobile par rapport au support, ladite structure mobile comportant une plateforme, dont une face au moins est destinée à recevoir la ou les particules à détecter, des moyens de suspension de la plateforme de sorte que la plateforme puisse être mise en vibration par rapport au support, des moyens de mise en vibration de ladite plateforme à au moins une de ses fréquences de résonance, des moyens de détection du déplacement de la plateforme dans une direction donnée, les moyens de suspension comportant au moins deux poutres configurées pour se déformer lorsque la plateforme est mise en vibration. Chaque poutre présente une longueur l, une largeur L et une épaisseur e et la plateforme présente une dimension dans la direction de déplacement de la plateforme. La dimension de chaque poutre dans la direction de déplacement donnée de la plateforme est au moins 10 fois plus petite que la dimension de la plateforme dans la direction de déplacement donnée, et dans le cas d'un dispositif de détection à mode dans le plan l ≥ 10 ×L et dans le cas d'un dispositif de détection à mode hors-plan l ≥ 10 ×e, de sorte que, lors de la mise en vibration de la plateforme, celle-ci ne soit pas ou peu déformée par l'action des poutres.

Dans un exemple de réalisation, les moyens de suspension comportent au moins une première poutre et une deuxième poutre, les première et deuxième poutres étant disposées symétriquement par rapport à la direction de déplacement.

Dans un exemple, les moyens d'actionnement peuvent être extérieurs à la structure mobile.

Dans un autre exemple, les moyens d'actionnement peuvent agir directement sur la plateforme. Les moyens d'actionnement peuvent être des moyens optiques appliquant une force de gradient à la fréquence de résonance à la plateforme ou des moyens électrostatiques appliquant une force électrostatique à la fréquence de résonance sur la plateforme.

Dans un exemple de réalisation, au moins deux poutres sont en matériau piézorésistif, par exemple en silicium, et les moyens de détection comportent une source de tension constante destinée à appliquer une différence de potentiel audites poutres, des moyens de mesure d'un courant en sortie desdites poutres.

Les moyens de détection peuvent comporter un résonateur optique disposé à proximité de la plateforme de sorte que le déplacement de la plateforme modifie un champ évanescent du résonateur optique, un guide d'onde destiné à injecter un faisceau lumineux dans le résonateur optique et à collecter ledit faisceau lumineux sortant du résonateur optique.

Dans un exemple avantageux, le dispositif de détection comporte plusieurs structures mobiles disposées autour du résonateur optique, le déplacement de chaque plateforme modifiant le champ évanescent du résonateur optique.

Dans un exemple de réalisation, la plateforme est rectangulaire et les deux poutres sont fixées à un premier côté de plus grande longueur de la plateforme et perpendiculairement audit premier côté, deux autres poutres sont fixées à un deuxième côté de plus grande longueur de la plateforme perpendiculairement audit deuxième côté. Les poutres peuvent être droites et parallèles entre elles.

Les poutres peuvent être fixées aux premier et deuxième côtés de plus grande longueur à distance des extrémités longitudinales des premier et deuxième côtés de plus grande longueur.

Dans un exemple de réalisation, les poutres sont réalisées dans un matériau différent de celui de la plateforme.

La présente invention a également pour objet un spectromètre de masse comportant, des moyens d'ionisation d'un analyte, des moyens de focalisation de l'analyte ionisé et au moins un dispositif de détection selon l'invention disposé en aval des moyens de focalisation.

## BRÈVE DESCRIPTION DES DESSINS

La présente invention sera mieux comprise sur la base de la description qui va suivre et des dessins en annexe sur lesquels :

- la figure 1 est une vue de dessus d'un exemple de réalisation d'un dispositif de détection à mode de déplacement dans le plan,
- la figure 2A est une vue en perspective du dispositif de détection de la figure 1,
- la figure 2B est une vue de détail de la figure 2A,
- la figure 3 est une représentation schématique du dispositif de la figure 1 en phase d'excitation,
- la figure 4 est une vue de dessus d'un dispositif de détection comportant des moyens de détection piézorésistifs,
- la figure 5A est une vue de dessus d'un exemple de dispositif de détection à déplacement dans le plan comportant des moyens de détection optiques,
- la figure 5B est une vue de dessus d'un exemple de dispositif à mode hors-plan comportant des moyens optiques pouvant servir à l'actuation ou à la détection,
- la figure 6 est une vue de dessus d'un autre exemple de réalisation du dispositif de la figure 1,
- la figure 7 est une vue de dessus d'un autre exemple de réalisation du dispositif de la figure 1,
- les figures 8A à 8D sont des vues de dessus de variantes de réalisation du dispositif selon l'invention,
- la figure 9 est une vue de côté d'un dispositif de détection selon un autre mode de réalisation à mode de déplacement hors-plan,
- la figure 10 est une vue de dessus d'un dispositif de détection selon encore un autre mode de réalisation,
- la figure 11 est une représentation schématique d'un spectromètre de masse mettant en œuvre un dispositif de détection selon l'invention,
- les figures 12A à 12C sont des représentations schématiques de vue de dessus et de côté d'éléments obtenus lors de différentes étapes d'un exemple de procédé de réalisation d'un dispositif de détection de la figure 1,

- la figure 13 est une vue de dessus représentée schématiquement d'un exemple de dispositif selon l'invention à actuation thermique,
- la figure 14 est une vue identique à celle de la figure 1 avec des particules déposées sur la plateforme,
- les figures 15A et 15B sont des représentations schématiques de vue de dessus et de côté d'éléments obtenus lors de différentes étapes d'un exemple de procédé de réalisation d'une variante du dispositif de détection de la figure 1,
- les figures 16A et 16B sont des représentations schématiques de vue de dessus et de côté d'éléments obtenus lors de différentes étapes d'un exemple de procédé de réalisation d'un dispositif de détection de la figure 9.

## EXPOSÉ DÉTAILLÉ DE MODES DE RÉALISATION PARTICULIERS

Le dispositif de détection résonant selon l'invention est destiné à détecter la présence de particules déposées sur une plateforme d'accueil. Les particules ont par exemple des dimensions de quelques nm. Les particules peuvent être des particules biologiques (molécules, protéines, virus, etc.), des particules contenues dans l'air ou du gaz.

Sur toutes les figures, les flèches représentent la direction de déplacement de la plateforme sous l'action des moyens d'actionnement.

Comme nous le verrons par la suite, le terme « poutre » désigne à la fois des éléments rectilignes de section transversale constante, des éléments non rectilignes, et des éléments de section variable continument et/ou par portion.

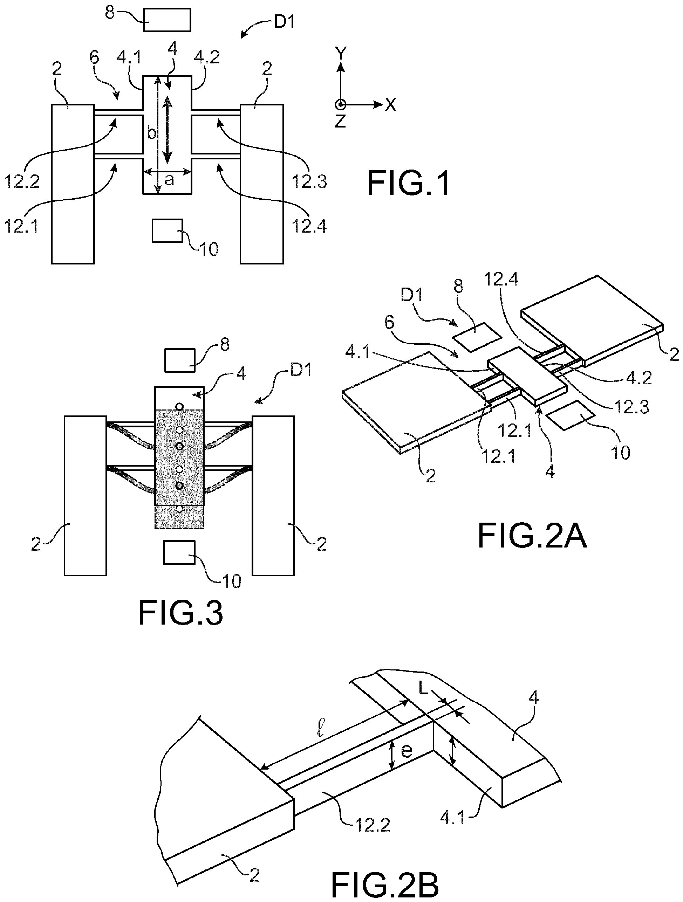

Sur les figures 1 et 2A, on peut voir un exemple de réalisation d'un dispositif de détection D1 à mode dans le plan selon l'invention.

Il comporte un support 2, une plateforme d'accueil 4 des particules, désigné « plateforme », des moyens de suspension 6 de la plateforme 4 au support 2, de sorte que la plateforme 4 est apte à se déplacer par rapport au support 2. Dans cet exemple, il est considéré que la plateforme 4 est destinée à se déplacer dans le plan XY du dispositif comme cela est schématisé sur la figure 3. Z est orthogonal au plan XY et sera désignée « direction hors-plan ».

La plateforme s'étend dans un plan qui est parallèle au plan XY du dispositif de détection.

Dans l'exemple représenté sur la figure 1, la plateforme comporte des ouvertures qui sont utilisées dans certains procédés de fabrication. Ces ouvertures peuvent être omises.

Le dispositif de détection comporte également des moyens d'actionnement 8 aptes à mettre la plateforme en vibration dans le plan XY à au moins une fréquence de résonance.

Le dispositif comporte également des moyens de détection 10 du déplacement de la plateforme 4, plus particulièrement des variations dans le déplacement de la plateforme dues au dépôt d'une particule sur la plateforme.

Les moyens de suspension comportent au moins deux poutres. Dans l'exemple représenté, les moyens de suspension 6 comportent quatre poutres 12.1, 12.2, 12.3, 12.4.

Chaque poutre 12 est ancrée par une extrémité au support 2 et par une autre extrémité à la plateforme 4.

Dans l'exemple représenté, la plateforme a une forme rectangulaire, deux poutres 12.1, 12.2 étant ancrées à la plateforme 4 le long d'un premier côté 4.1 de la plateforme, et les deux autres poutres 12.3, 12.4 sont ancrées à la plateforme le long d'un deuxième côté 4.2 parallèle au premier côté.

Dans l'exemple représenté, les poutres 12.1, 12.2 sont ancrées à la plateforme à distance des extrémités longitudinales du premier côté 4.1 et les poutres 12.3, 12.4 sont ancrées à la plateforme à distance des extrémités longitudinales du deuxième côté 4.2. En variante, les poutres sont ancrées à la plateforme au niveau des extrémités longitudinales des deuxièmes côtés.

Dans cet exemple, les poutres 12.1 et 12.2 sont parallèles entre elles et les poutres 12.3 et 12.4 sont parallèles entre elles, les poutres 12.1 et 12.3 sont alignées et les poutres 12.2 et 12.4 sont alignées et sont parallèles à l'axe X.

Dans cet exemple, les poutres ont une section transversale constante dans un plan YZ.

Les poutres ont une longueur l dans la direction X, une largeur L dans la direction Y et une épaisseur e dans la direction Z (figure 2B).

Les dimensions de la plateforme sont désignés a dans la direction X et b dans la direction Y.

Comme cela est schématisé sur la figure 3, la plateforme 4 est destinée à se déplacer le long de la direction Y. Les 12.1 à 12.4 sont alors déformées en flexion.

La structure mobile comprenant la plateforme et les poutres, est dimensionnée de sorte que lors du déplacement de la plateforme et de la déformation des poutres, la plateforme ne soit pas ou peu déformée sous l'action des poutres.

Pour cela on choisit :

(Ia) - Pour un fonctionnement dans le plan, la longueur l des poutres égale à au moins 10 fois la largeur L de la poutre :

$$l \geq 10 \times L.$$

(II) - la dimension des poutres dans la direction de déplacement de la plateforme est au moins 10 fois plus petite que la dimension de la plateforme dans la direction de déplacement.

Dans l'exemple des figures 1 à 3, la direction de déplacement est la direction Y dans le plan, alors $L \leq b/10$.

La plateforme peut avoir des dimensions, par exemple, de 100 nm x100 nm de surface jusqu'à 100 $\mu$m x 100 $\mu$m, quel que soit le mode de fonctionnement. L'épaisseur de la plateforme peut être par exemple de 10 nm à 100 $\mu$m.

Les poutres peuvent par exemple avoir une section comprise entre 25 nm x25 nm et 10 $\mu$m x10 $\mu$m; et une longueur comprise entre 250 nm et 100 $\mu$m.

Un exemple de dimensions non limitatif est donné ci-dessous. Le dispositif comporte une plateforme rectangulaire suspendue par quatre poutres pour un mode dans le plan. La plateforme et les poutres ont une épaisseur dans la direction Z de 220 nm. La plateforme a des dimensions extérieurs de 3 $\mu$m x 1,5 $\mu$m. Les poutres ont une longueur dans la direction X de 1, 5 $\mu$m et une section de 100 nm x 220 nm.

Dans un autre exemple de réalisation d'un dispositif adapté à une fonctionnement en mode hors-plan, la plateforme a une surface de 3 $\mu$m x 1,5 $\mu$m et une épaisseur de 300 nm Les supports ont une longueur de 1 $\mu$m, une dimension L de 100 nm et une épaisseur e de 30 nm.

Ainsi les poutres présentent une raideur sensiblement plus faible que la raideur de la plateforme dans la direction de déplacement, ce qui réduit les risques de déformation de la plateforme dans la direction de déplacement.

La masse Mm de la particule capable d'être mesurée est très inférieure à la masse de la plateforme Mp, avantageusement Mm < Mp/10.

La masse minimale mesurable par le dispositif de détection dépend, quant à elle, des performances du dispositif de détection.

Dans un exemple de réalisation, les moyens d'actionnement sont extérieurs à la structure mobile et comportent un élément vibrant piézoélectrique, également appelé piezoshaker, auquel est fixé le support 2. Lorsque le piezoshaker est activé, la structure mobile est mise en mouvement par rapport au support. Par exemple, si l'actionnement mécanique est à une fréquence de résonance, une amplification mécanique apparaît et la plateforme se déplace par rapport au support.

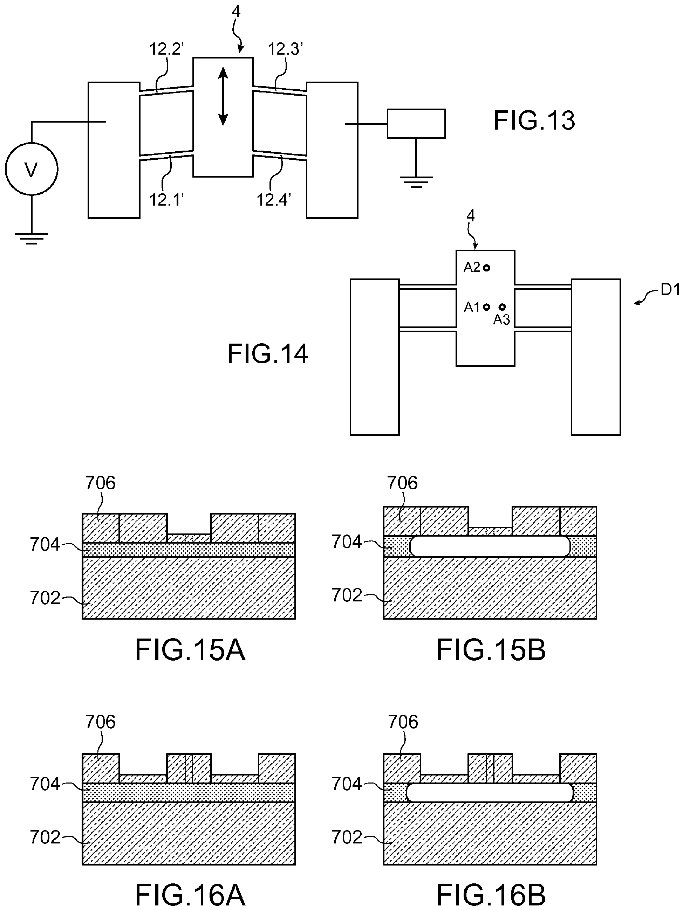

Sur la figure 13, on peut voir un autre exemple de réalisation de dispositif adapté au mode dans le plan, dans lequel les moyens d'actionnement sont de type thermique. Pour cela un courant circule à travers de la structure. Le courant échauffe principalement les poutres par effet Joule, qui sont les éléments les plus résistifs du fait de leur faible section. Le réchauffement cause une dilatation des supports, qui provoque une force d'actionnement dans le plan. La détection est piézoélectrique. Les poutres 12.1' à 12.4' sont orientées par rapport aux bords de la plateforme 4 de sorte à former un angle non droit avec ceux-ci.

On considère une tension d'actuation à la fréquence $f_{0/2}$.

Les poutres piézorésistives de résistance R voient leur résistance variée selon $R = R_0 + R_1 cps f_0$.

Le déplacement de la plateforme du fait de l'actuation thermique s'écrit :

$$x = x_0 \cos f_0.$$

Le courant de détection en sortie est :

$$I = I_1 \cos f_0/2 + I_1 \cos(f_0 - f_0/2) + I_1 \cos(f_0 + f_0/2)$$

$I_1 \cos(f_0 - f_0/2) + I_1 \cos(f_0 + f_0/2)$ est le courant résultant du mouvement de la structure.

Dans un autre exemple de réalisation, les moyens d'actionnement sont de type électrostatique. Par exemple, il comporte une électrode sur le support en regard d'une face de la plateforme et orientée de sorte qu'une force électrostatique générée entre l'électrode et la plateforme, déplace la plateforme dans la direction Y. Dans l'exemple de la figure 1, l'électrode est disposée en regard d'un côté 4.2. En appliquant une différence de potentiel avec une composante constante et une deuxième composante à la fréquence de résonance entre l'électrode et la plateforme, une force électrostatique proportionnelle au carré de la différence de potentiel, apparaît entre l'électrode et la plateforme, qui est alors mise en vibration à la fréquence de résonance. En variante, on peut envisager de mettre en œuvre deux électrodes, chacune en regard d'un côté de la plateforme, les différences de potentiel appliquées aux électrodes sont alors déphasées d'une demi-période.

Selon un autre exemple de réalisation, les moyens d'actionnement sont de type optique. Ils comportent par exemple un résonateur optique, par exemple en forme d'anneau, disposé à proximité de la plateforme. Lorsque le résonateur optique est à la résonance, une force de gradient apparaît attirant la plateforme vers l'anneau. La force de gradient est modulée à la fréquence de résonance, provoquant une mise en vibration de la plateforme. Le ou les anneaux optiques sont mis en regard d'un côté 4.2 dans l'exemple des figures 1 à 3.

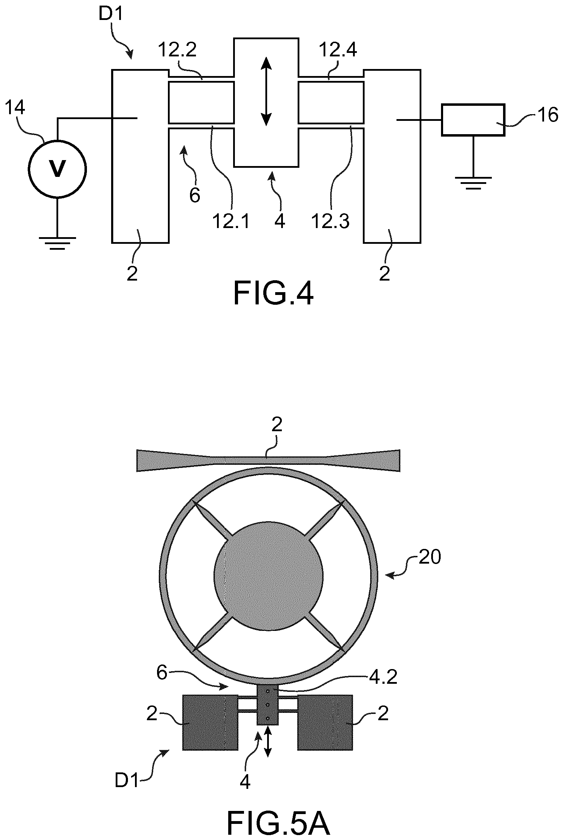

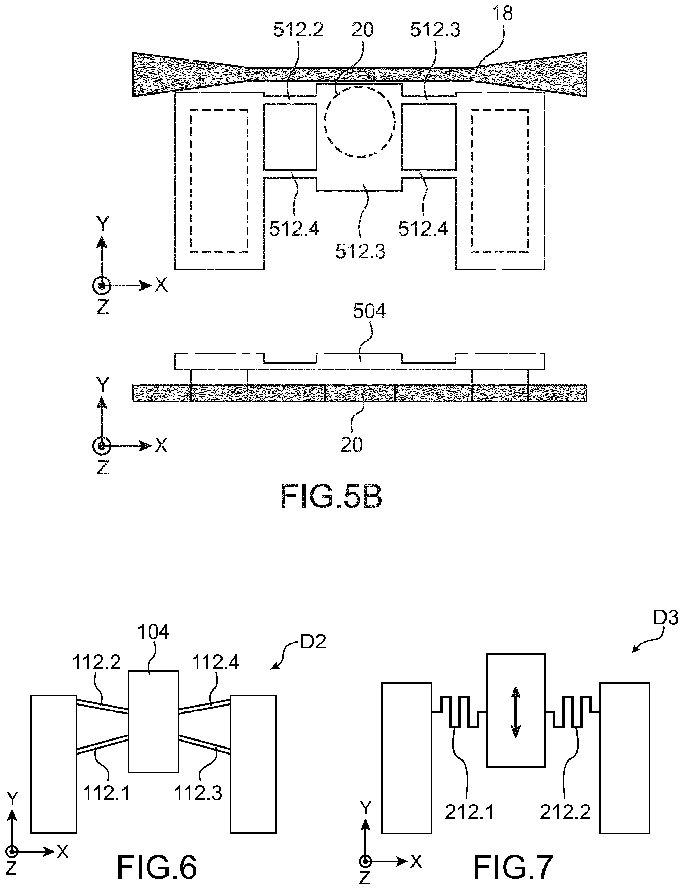

Sur les figures 4 et 5, on peut voir des exemples de moyens de détection pouvant être mis en œuvre dans le dispositif de détection.

Sur la figure 4, les moyens de détection sont de type piézorésistif. Les moyens de détection mettent en œuvre tout ou partie des poutres 12.1 à 12.4 formées en un matériau piézorésistif. Les poutres sont par exemple en silicium.

Dans l'exemple représenté, les quatre poutres sont en matériau piézorésistif et participent à la mise en vibration de la plateforme. Dans un autre exemple, seules les poutres 12.1 et 12.3 ou 12.2 et 12.4 sont en matériau piézorésistif.

Les moyens de détection comportent également une source 14 de tension constante V et des moyens de mesure 16 du courant de sortie I.

Dans un mode homodyne, la source de tension constante est par exemple reliée au support auquel sont ancrées les poutres 12.1, 12.2, et les moyens de mesure 16 du courant de sortie sont reliés au support auquel sont ancrées les poutres 12.3, 12.4.

Par exemple, en supposant un déplacement de la plateforme le long de la direction Y : $y = y_0\cos f_0$, $f_0$ étant la fréquence de résonance, alors la résistance R de poutres piézorésistives varie selon la relation suivante :

$$R = R_0 + R_1\cos 2f_0.$$

Il en résulte que le courant de sortie peut s'écrire $I = I_0 I_1 \cos 2f_0$.

Si l'on combine un actionnement thermique avec une détection piézorésistive, la résistance des supports varie selon la relation $R = R_0 + R_1\cos f_0$, car les poutres forment un angle avec les bords de la plateforme. Dans ce cas, le courant qui traverse la structure est à fréquence $f_0/2$ à cause de l'actionnement thermique, de façon que le courant de sortie ait des termes à trois fréquences différentes : à celle de la fréquence d'actionnement, et deux composants supplémentaires qui n'apparaissent que quand la structure est en résonance. Ces composants peuvent être mesurés en utilisant des méthodes de détection hétérodyne ou bien un analyseur de spectres.

Si une particule se dépose sur la plateforme, la fréquence de résonance est modifiée, provoquant une variation de R et une variation de I. En traitant cette variation, on peut remonter à la masse de la particule déposée.

En variante, on peut réaliser une détection hétérodyne, en mettant en œuvre une source de tension modulée à une certaine fréquence, la fréquence du courant de sortie étant connue et fixe.

La mise en œuvre de moyens de détection piézoélectrique présente l'avantage d'être d'encombrement réduit, ce qui permet d'optimiser la surface de capture sur une même puce.

Sur la figure 5A, on peut voir un autre exemple de réalisation de moyens de détection, dans lequel les moyens de détection sont de type optique, adapté à un dispositif ayant un mode dans le plan.

Dans l'exemple représenté, les moyens de détection comportent un dispositif optique comprenant au moins un guide d'onde 18 et un résonateur optique 20 en forme d'anneau, qui est couplé au guide d'onde 18 par un couplage évanescent. Le dispositif optique comporte également une source lumineuse, par exemple un laser (non représenté) couplé optiquement au guide d'onde 18.

L'anneau optique 20 est fixé au support 2 et situé à proximité de la plateforme, de sorte qu'un bord au moins de la plateforme soit dans le champ évanescent de l'anneau et que le déplacement de l'anneau influence le champ évanescent. Par exemple, la distance entre l'anneau et un bord de la plateforme est de l'ordre de 100 nm.

L'orientation de l'anneau par rapport à la plateforme est telle que lors de la mise en vibration de la plateforme, la distance entre l'anneau et la plateforme varie, tout en restant dans le périmètre du champ évanescent.

On injecte dans l'anneau optique une onde lumineuse de puissance constante. Le déplacement de la plateforme à proximité de l'anneau modifie les propriétés optiques de l'anneau, dont sa fréquence de résonance optique, la puissance lumineuse récupérée par le guide d'onde 18 est alors modulée du fait de l'influence du déplacement de la plateforme sur les propriétés optiques de l'anneau. En utilisant des moyens spectrométriques, il est possible d'obtenir une puissance de sortie du faisceau lumineux proportionnelle au déplacement de la plateforme.

Pour une plateforme ayant un déplacement le long de la direction Y $y = y_0\cos f_0$, en considérant en entrée du guide d'onde, une puissance lumineuse à une longueur d'onde $\lambda_0$ constante $P_{in,\lambda 0}$, la puissance de sortie $P_{out,\lambda 0}$ est modulée en $P_1 + P_2\cos f_0$.

En variante, les moyens de détection optiques comportent un laser externe et des moyens de détection interférométriques.

En variante, on peut envisager de disposer plusieurs plateformes autour d'un même anneau optique, chaque plateforme étant couplée optiquement à l'anneau. En mettant en œuvre des plateformes de fréquences de résonances différentes, il est possible après traitement de séparer les influences des différentes plateformes sur les propriétés optiques de l'anneau et ainsi de remonter à la masse de chaque particule déposée sur chaque plateforme. Ce dispositif permet de détecter simultanément plusieurs particules, le dispositif offre alors une détection plus rapide.

Un exemple de fonctionnement du dispositif de détection selon l'invention va maintenant être décrit.

Les moyens d'actionnement 10, par exemple optiques ou électrostatiques, sont activés de sorte à mettre en vibration, à une de ses fréquences de résonances, la plateforme 4 le long de la direction Y, les poutres 12.2 à 12.4 sont déformées en flexion comme cela est représenté sur la figure 3. Du fait des dimensions des poutres et de la plateforme, les déformations des poutres n'ont pas ou peu d'effet mécanique sur la plateforme, celle-ci est peu ou n'est pas déformée.

Les moyens de détection, par exemple optiques ou piézoélectriques, détectent le déplacement vibratoire de la plateforme.

Lorsqu'une particule se dépose sur la plateforme, l'ensemble particule et plateforme présente une fréquence de résonance différente de celle de la plateforme seule. Les moyens de détection détectent le déplacement vibratoire modifié de la plateforme portant la particule.

La variation de fréquence de résonance est ensuite traitée et permet de remonter à la masse de la particule déposée.

Le dispositif de détection est intégré à un système de détection comportant des moyens de traitement des signaux de mesure fournis par le dispositif de détection, afin de fournir la masse de la particule déposée, voire la désignation de la particule déposée.

Grâce à l'invention, quel que soit l'endroit de la plateforme où la particule se dépose, l'influence sur la fréquence de résonance est la même ou quasiment la même. Ainsi un seul mode de résonance suffit pour détecter une particule quel que soit son emplacement sur la plateforme.

Sur la figure 14, on peut voir un dispositif selon la figure 1. Des particules A1, A2, A3 ont été schématisées à différents emplacements de la plateforme. Une simulation par éléments finis donne les résultats suivants :

Pour des particules de masse $m_1$ :

- le dépôt de la particule A1 provoque un décalage de fréquence

$$\frac{\Delta f_1}{f_0} = 1082,1 \; ppm \, ;$$

- le dépôt de la particule A2 provoque un décalage de fréquence

$$\frac{\Delta f_2}{f_0} = 1082,5 \; ppm;$$

- le dépôt de la particule A3 provoque un décalage de fréquence

$$\frac{\Delta f_3}{f_0} = 1082,0 \; ppm \, ;$$

On constate donc que, grâce à l'invention, le décalage de fréquence dû au dépôt d'une particule sur la plateforme varie peu en fonction de l'emplacement du dépôt.

Pour une masse $m_2 = m_1/2$ kg, la simulation donne pour la particule A1 $\frac{\Delta f_1}{f_0} = 541 \; ppm.$ En divisant par deux la masse, le décalage de fréquence est divisée environ par deux.

La surface de la plateforme peut être très grande et être ajustée en fonction des applications.

La fréquence de résonance de la plateforme est ajustée facilement en choisissant le dimensionnement des poutres des moyens de suspension, indépendamment de la forme de la plateforme.

Dans l'exemple représenté sur les figures 1 à 3, les poutres sont parallèles entre elles. Selon un autre exemple de dispositif D2 représenté sur la figure 6, les poutres de suspension de la plateforme 104 peuvent être orientées de sorte que leurs axes longitudinaux soient sécants. Dans l'exemple représenté, les poutres 112.1 et 112.2 et les poutres 112.3 et 112.4 sont disposées symétriquement par rapport à l'axe Y.

En outre, les poutres 212.1, 212.2 peuvent présenter une forme autre qu'une forme rectiligne, par exemple elles peuvent avoir la forme de ressort, telles que cela est visible dans le dispositif D3 représenté sur la figure 7. Dans ce cas la longueur à prendre en compte dans les inégalités l ≥ 10 ×L et l ≥ 10 ×e est la longueur du ressort développée.

En outre, les poutres peuvent présenter une section transversale de surface variable continument ou par portion. Dans ce cas, les inégalités (I) considèrent les valeurs maximales de L et e, et les inégalités (II) considère la valeur minimale de e.

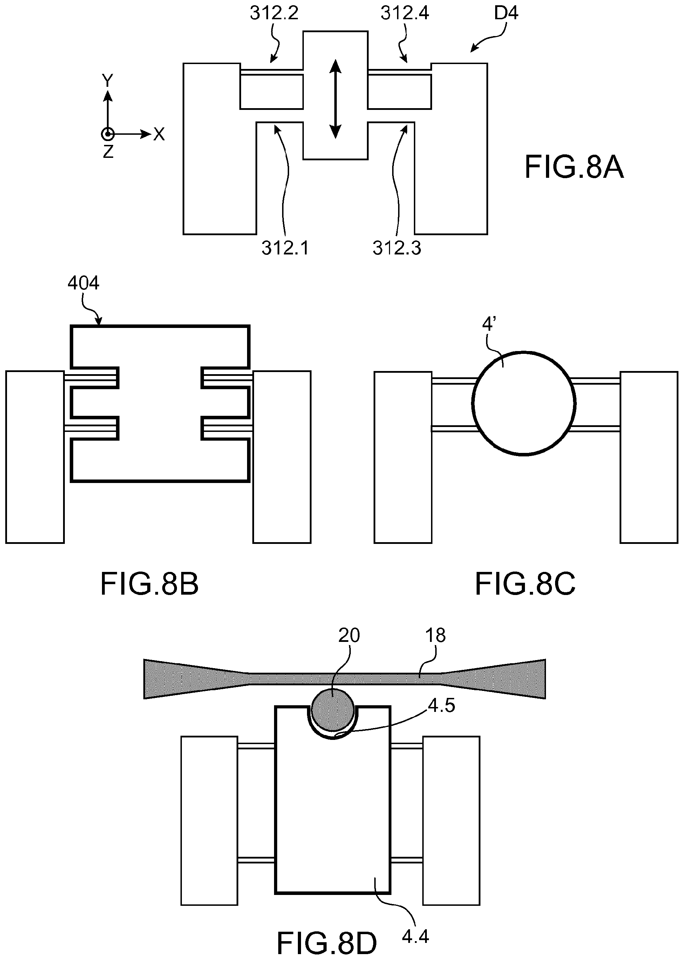

De plus, les poutres pourraient ne pas toutes avoir la même longueur, comme cela est représenté sur la figure 8A, sur laquelle les poutres 312.1 et 312.3 du dispositif D4 sont plus courtes que les poutres 312.2 et 312.4.

Sur la figure 8B, on peut voir une variante du dispositif D1 dans laquelle la plateforme 404 comporte des évidements 414 dans la direction X, pour chacune des poutres et au fond desquels une extrémité des poutres 412.1 à 412.4 est ancrée.

Sur la figure 8C, on peut voir une autre variante du dispositif D1 comportant une plateforme 4' en forme de disque.

Sur la figure 8D, on peut voir une variante du dispositif à actuation ou détection optique. Dans cet exemple, un bord de la plateforme 4" présente un évidement 4.5 de forme correspondante au disque optique pour loger celui-ci. Le disque optique 20 est partiellement bordé par un bord en forme d'arc de la plateforme.

Il sera compris également que le nombre de poutres n'est pas limité à quatre, il peut être envisagé de prévoir six poutres ou plus. De préférence, les poutres sont réparties symétriquement par rapport à la direction de déplacement pour obtenir un déplacement uniforme de la plateforme.

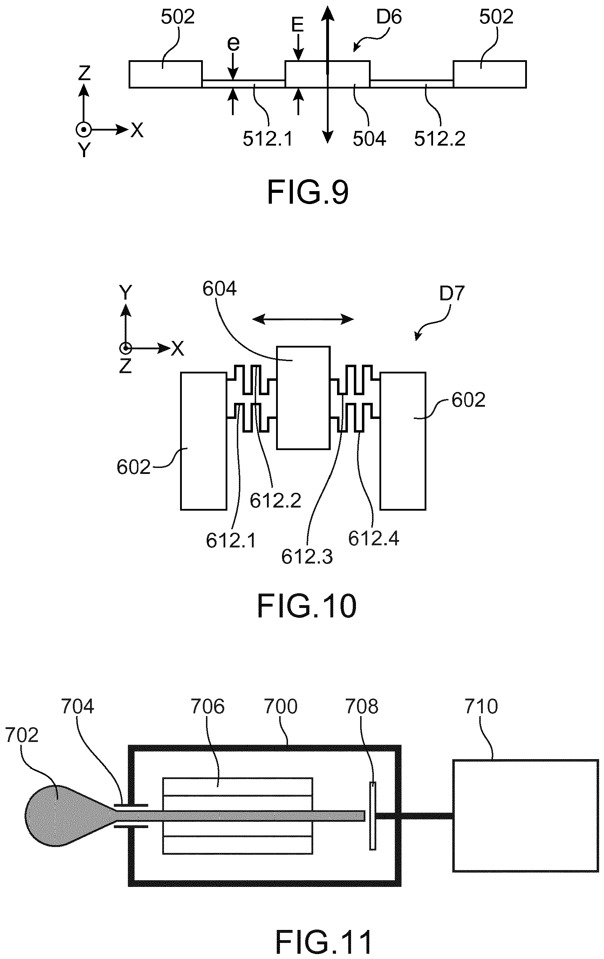

Dans un autre exemple de réalisation d'un dispositif de détection D6, la plateforme est excitée de sorte qu'elle ait un mouvement hors-plan, i.e. le long de l'axe Z, tel que cela est schématisé sur la figure 9.

La structure mobile comprenant la plateforme et les poutres, est dimensionnée de sorte que lors du déplacement de la plateforme et de la déformation des poutres, la plateforme ne soit pas ou peu déformée sous l'action des poutres.

Pour cela on choisit, pour les poutres 512.1 et 512.2 reliant la plateforme 504 aux supports 502 :

- lb - Pour un fonctionnement hors-plan pour lequel un exemple de dispositif sera décrit ci-dessous, la longueur l des poutres égale à au moins 10 l'épaisseur e de la poutre :

$$l \geq 10 \times e.$$

- La condition II s'écrit $L \leq 10xE$, avec E l'épaisseur de la plateforme dans la direction Z.

Selon l'invention, la plateforme se déplace le long de l'axe Z sans se déformer en flexion.

Les moyens d'actionnement aptes à mettre en mouvement la plateforme 404 le long de la direction Z, peuvent être les mêmes que ceux mis en œuvre pour générer un déplacement dans le plan. Dans le cas d'un shaker piézoélectrique, celui-ci est telle qu'il déplace le support dans la direction Z.

Sur la figure 5B, on peut voir un exemple de dispositif à mode hors-plan comportant des moyens optiques pouvant servir à l'actuation ou à la détection.

Les moyens de détection comportent un anneau optique disposé sous la plateforme et un guide d'onde 18 dans le plan de l'anneau. Dans le cas d'une mise en œuvre pour la détection, le déplacement de la plateforme selon la direction Z, à proximité de l'anneau modifie les propriétés optiques de l'anneau, dont sa fréquence de résonance optique. La puissance lumineuse récupérée par le guide d'onde 18 est alors modulée du fait de l'influence du déplacement de la plateforme sur les propriétés optiques de l'anneau. Dans cet exemple, la plateforme protège avantageusement l'anneau optique du dépôt de masse, ce qui évite des effets de la masse rajoutés sur la réponse optique.

Les moyens de détection aptes à détecter le déplacement de la plateforme peuvent être similaires à ceux mis en œuvre pour la détection des déplacements dans le plan.

Selon un autre exemple de réalisation, la plateforme 604 peut être excitée suivant des modes transversales dans le plan par rapport au support 602, i.e. des modes dans lesquels la direction de mouvement correspond à la direction longitudinale des poutres 612.1 à 612.4, i.e. selon la direction dans la représentation de la figure 10. Les poutres ont de préférence une forme de ressort.

Sur la figure 11, on peut voir une représentation schématique d'un spectromètre de masse mettant en œuvre le dispositif de détection selon l'invention.

Le spectromètre de masse comporte une chambre à vide 700 alimentée par une source d'analyte 702, des moyens d'ionisation 704 de l'analyte en entrée de la chambre 700, des moyens de focalisation 706 de l'analyte ionisée en aval des moyens d'ionisation et un capteur de masse 708 selon l'invention en aval des moyens de focalisation. Le capteur est relié à des moyens de mesure et de traitement du signal 710 émis par le capteur 708.

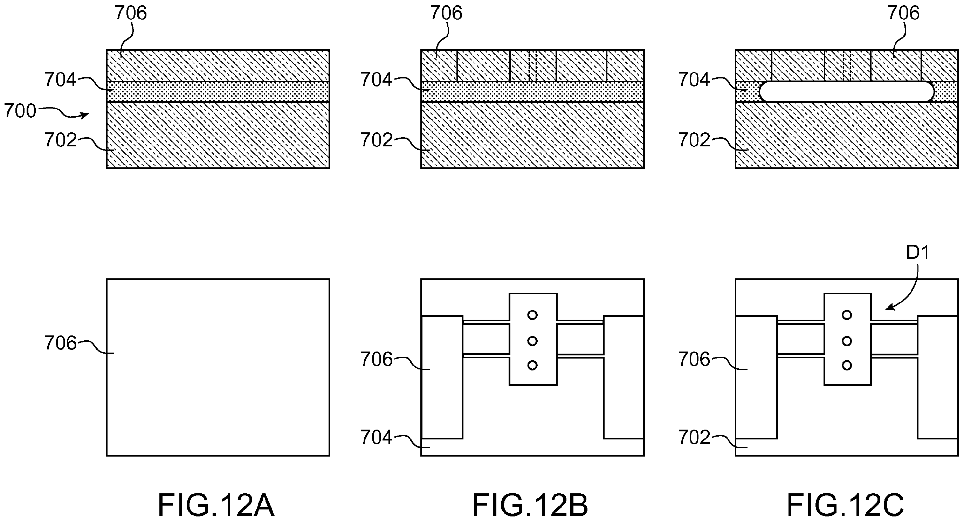

Un exemple de procédé de fabrication d'un dispositif de détection des figures 1 à 3 va maintenant être décrit en relation avec les figures 12A à 12C.

De préférence, le dispositif de détection peut être réalisé par des techniques de la microélectronique.

Par exemple, on utilise un substrat SOI 700 (Silicon On Insulator en terminologie anglo-saxonne) ou silicium sur isolant comportant un substrat en silicium 702, une couche de $SiO_2$ 704 et une couche de silicium 706. Ce substrat est représenté vu de côté et vu de dessus sur la figure 12A.

Lors d'une étape suivante, on structure la couche 706 par exemple par photolithographie et gravure, de sorte à former la structure mobile dans la couche 706 présentant les dimensionnements adaptés des poutres et de la plateforme pour assurer une faible déformation, voire une absence de déformation de la plateforme lors de sa mise en vibration.

L'élément ainsi obtenu est représenté en vue de côté et en vue de dessus sur la figure 12B.

Lors d'une étape suivante, on libère la structure mobile, par exemple par gravure humide anisotrope du $SiO_2$ 704.

L'élément ainsi obtenu est représenté en vue de côté et en vue de dessus sur la figure 12C.

Il sera compris que la structure mobile peut être réalisée dans un autre matériau, comme gallium, nitrure de silicium ou aluminium.

En outre, dans l'exemple décrit la plateforme et les poutres sont dans le même matériau. Dans un autre exemple, ils sont réalisés dans des matériaux différents, présentant par exemple des propriétés mécaniques différentes. Par exemple, on peut réaliser la plateforme dans un matériau présentant une plus grande raideur et les poutres présentant une plus faible raideur, par exemple en choisissant un matériau avec un module d'Young plus élevée pour la plateforme que pour les poutres. Par exemple, on peut choisir dans le cas d'un dispositif à déplacement dans le plan Epoutre x L << Eplateforme x b, et dans le cas d'un dispositif à déplacement hors-plan Epoutre x e << Eplateforme x E

Avec Epoutre le module d'Young du matériau de la poutre, Eplateforme le module d'Young du matériau de la plateforme et E l'épaisseur de la plateforme.

En outre, on peut envisager de réalisation l'empilement de la figure 12A, et non de partir d'un empilement déjà réalisé.

La taille minimale du dispositif de détection dépend du procédé de fabrication et de son aptitude à réaliser des poutres de faible section. Par exemple, si la technologie de fabrication limite la dimension minimale d'un élément à 50 nm, la plus petite section des poutres peut être 50 nm x50 nm, il en résulte que la longueur des poutres est au moins de de 500nm, et la plateforme a au moins une dimension minimale de 500nm dans la direction de mouvement.

Sur les figures 15A et 15B, on peut voir représentées schématiquement les étapes permettant de réaliser un dispositif à mode dans le plan, dans lequel la plateforme est amincie et les poutres sont épaisses.

On réalise tout d'abord les étapes des figures 12A et 12B, puis on réalise une photolithographie et une gravure de la plateforme de sorte à l'amincir.

L'élément ainsi obtenu est représenté sur la figure 15A.

Lors d'une étape suivante, on libère la structure mobile, par exemple par gravure humide anisotrope du $SiO_2$ 704.

L'élément ainsi obtenu est représenté en vue de côté sur la figure 15B.

Sur les figures 16A et 16B, on peut voir représentées schématiquement les étapes permettant de réaliser un dispositif à mode hors-plan (figure 9), dans lequel les poutres sont amincies par rapport à la plateforme.

On réalise tout d'abord les étapes des figures 12A et 12B, puis on réalise une photolithographie et une gravure des poutres de sorte à les amincir.

L'élément ainsi obtenu est représenté sur la figure 16A.

Lors d'une étape suivante, on libère la structure mobile, par exemple par gravure humide anisotrope du $SiO_2$ 704.

L'élément ainsi obtenu est représenté en vue de côté sur la figure 16B.

## Revendications

1. Dispositif de détection de particules comportant un support et au moins une structure mobile par rapport au support (2), ladite structure mobile comportant une plateforme (4), dont une face au moins est destinée à recevoir la ou les particules à détecter, des moyens de suspension (6) de la plateforme (4) de sorte que la plateforme (4) puisse être mise en vibration par rapport au support(2), des moyens de mise en vibration (8) de ladite plateforme (4) à au moins une de ses fréquences de résonance, des moyens de détection (10) du déplacement de la plateforme (4) dans une direction donnée, les moyens de suspension (6) comportant au moins deux poutres (12.1, 12.2, 12.3, 12.4), configurées pour se déformer lorsque la plateforme (4) est mise en vibration, dans lequel chaque poutre (12.1, 12.2, 12.3, 12.4) présente une longueur l, une largeur L et une épaisseur e et la plateforme (4) présente une dimension dans la direction de déplacement de la plateforme, **caractérisé en ce que**

   - la dimension de chaque poutre dans la direction de déplacement donnée de la plateforme (4) est au moins 10 fois plus petite que la dimension de la plateforme (4) dans la direction de déplacement donnée, et
   - dans le cas d'un dispositif de détection à mode dans le plan $l \geq 10 \times L$ et dans le cas d'un dispositif de détection à mode hors-plan $l \geq 10 \times e$,
   de sorte que, lors de la mise en vibration de la plateforme (44), celle-ci ne soit pas ou peu déformée par l'action des poutres.

**2.** Dispositif de détection selon la revendication 1, dans lequel les moyens de suspension (6) comportent au moins une première poutre et une deuxième poutre, les première et deuxième poutres étant disposées symétriquement par rapport à la direction de déplacement.

**3.** Dispositif de détection selon la revendication 1 ou 2, dans lequel les moyens d'actionnement (8) sont extérieurs à la structure mobile.

**4.** Dispositif de détection selon la revendication 1 ou 2, dans lequel les moyens d'actionnement (8) agissent directement sur la plateforme.

**5.** Dispositif de détection selon la revendication 4, dans lequel les moyens d'actionnement (8) sont des moyens optiques appliquant une force de gradient à la fréquence de résonance à la plateforme ou des moyens électrostatiques appliquant une force électrostatique à la fréquence de résonance sur la plateforme.

**6.** Dispositif de détection selon l'une des revendications 1 à 5, dans lequel au moins deux poutres sont en matériau piézorésistif, par exemple en silicium, et dans lequel les moyens de détection comportent une source de tension constante (14) destinée à appliquer une différence de potentiel audites poutres, des moyens de mesure (16) d'un courant en sortie desdites poutres.

**7.** Dispositif de détection selon l'une des revendications 1 à 6, dans lequel les moyens de détection comportent un résonateur optique (20) disposé à proximité de la plateforme (4) de sorte que le déplacement de la plateforme (4) modifie un champ évanescent du résonateur optique (20), un guide d'onde (18) destiné à injecter un faisceau lumineux dans le résonateur optique (20) et à collecter ledit faisceau lumineux sortant du résonateur optique (20).

**8.** Dispositif de détection selon l'un des revendications 1 à 5 et 7, comportant plusieurs structures mobiles disposées autour du résonateur optique, le déplacement de chaque plateforme modifiant le champ évanescent du résonateur optique.

**9.** Dispositif de détection selon l'une des revendications 1 à 8, dans lequel la plateforme (4) est rectangulaire, dans lequel deux poutres (12.1, 12.2) sont fixées à un premier côté de plus grande longueur (4.1) de la plateforme (4) et perpendiculairement audit premier côté (4.1), deux autres poutres (12.3, 12.4) sont fixées à un deuxième côté de plus grande longueur (4.1) de la plateforme (4) perpendiculairement audit deuxième côté (4.1), et dans lequel les poutres (12.1, 12.2, 12.3, 12.4) sont droites et parallèles entre elles.

**10.** Dispositif de détection selon la revendication 9, dans lequel les poutres (12.1, 12.2, 12.3, 12.4) sont fixées aux premier et deuxième côtés (4.1) de plus grande longueur à distance des extrémités longitudinales des premier et deuxième côtés de plus grande longueur (4.1).

**11.** Dispositif de détection selon l'une des revendications 1 à 10, dans lequel les poutres sont réalisées dans un matériau différent de celui de la plateforme.

**12.** Spectromètre de masse comportant, des moyens d'ionisation d'un analyte, des moyens de focalisation de l'analyte ionisé et au moins un dispositif de détection selon l'une des revendications 1 à 11 disposé en aval des moyens de focalisation.

**Patentansprüche**

**1.** Vorrichtung zur Detektion von Partikeln, umfassend einen Träger und wenigstens eine bezüglich des Trägers (2) bewegliche Struktur, wobei die bewegliche Struktur eine Plattform (4) umfasst, von der wenigstens eine Fläche dazu ausgelegt ist, das oder die zu detektierende Partikel zu empfangen, Mittel (6) zur Aufhängung der Plattform (4) derart, dass die Plattform (4) bezüglich des Trägers (2) in Vibration versetzt werden kann, Mittel (8) zum Invibrationversetzen der Plattform (4) bei wenigstens einer ihrer Resonanzfrequenzen, Mittel (10) zur Detektion der Verlagerung der Plattform (4) in einer gegebenen Richtung, wobei die Aufhängungsmittel (6) wenigstens zwei Balken (12.1, 12.2, 12.3, 12.4) umfassen, die dazu konfiguriert sind, sich zu verformen, wenn die Plattform (4) in Vibration versetzt wird, wobei jeder Balken (12.1, 12.2, 12.3, 12.4) eine Länge l, eine Breite L und eine Dicke e aufweist, und die Plattform (4) eine Abmessung in der Verlagerungsrichtung der Plattform aufweist, **dadurch gekennzeichnet, dass**

- die Abmessung jedes Balkens in der gegebenen Verlagerungsrichtung der Plattform (4) wenigstens 10 Mal kleiner ist als die Abmessung der Plattform (4) in der gegebenen Verlagerungsrichtung, und
- im Fall einer Detektionsvorrichtung mit einem Modus in der Ebene, l ≥ 10 x L, und im Fall einer Detektionsvorrichtung mit einem Modus außerhalb der Ebene l ≥ 10 x e,

derart, dass dann, wenn die Plattform (44) in Vibration versetzt wird, diese durch die Wirkung der Balken nicht oder wenig verformt wird.

2. Detektionsvorrichtung nach Anspruch 1, bei der die Aufhängungsmittel (6) wenigstens einen ersten Balken und einen zweiten Balken umfasst, wobei der erste und der zweite Balken symmetrisch mit Bezug zu der Verlagerungsrichtung angeordnet sind.

3. Detektionsvorrichtung nach Anspruch 1 oder 2, bei der die Betätigungsmittel (8) außerhalb der beweglichen Struktur sind.

4. Detektionsvorrichtung nach Anspruch 1 oder 2, bei der die Betätigungsmittel (8) direkt auf die Plattform wirken.

5. Detektionsvorrichtung nach Anspruch 4, bei der die Betätigungsmittel (8) optische Mittel sind, die eine Gradientenkraft mit der Resonanzfrequenz auf die Plattform ausüben, oder elektrostatische Mittel, die eine elektrostatische Kraft mit der Resonanzfrequenz auf die Plattform ausüben.

6. Detektionsvorrichtung nach einem der Ansprüche 1 bis 5, bei der wenigstens zwei Balken aus einem piezoresistiven Material sind, beispielsweise aus Silizium, und bei der die Detektionsmittel eine Gleichspannungsquelle (14) umfassen, die dazu ausgelegt ist, eine Potentialdifferenz an die Balken anzulegen, und Mittel (16) zum Messen eines Stroms am Ausgang der Balken.

7. Detektionsvorrichtung nach einem der Ansprüche 1 bis 6, bei der die Detektionsmittel einen optischen Resonator (20) umfassen, der in der Nähe der Plattform (4) derart angeordnet ist, dass die Verlagerung der Plattform (4) ein evaneszentes Feld des optischen Resonators (20) verändert, und einen Wellenleiter (18), der dazu ausgelegt ist, einen Lichtstrahl in den optischen Resonator (20) zu injizieren und den Lichtstrahl einzusammeln, der aus dem optischen Resonator (20) austritt.

8. Detektionsvorrichtung nach einem der Ansprüche 1 bis 5 und 7, umfassend mehrere bewegliche Strukturen, die um den optischen Resonator herum angeordnet sind, wobei die Verlagerung jeder Plattform das evaneszente Feld des optischen Resonators verändert.

9. Detektionsvorrichtung nach einem der Ansprüche 1 bis 8, bei der die Plattform (4) rechteckig ist, wobei zwei Balken (12.1, 12.2) an einer ersten Seite mit größerer Länge (4.1) der Plattform (4) befestigt sind, und orthogonal zu der ersten Seite (4.1) zwei andere Balken (12.3, 12.4) an einer zweiten Seite mit größerer Länge (4.1) der Plattform (4) orthogonal zu der zweiten Seite (4.1) befestigt sind, und wobei die Balken (12.1, 12.2, 12.3, 12.4) gerade und zueinander parallel sind.

10. Detektionsvorrichtung nach Anspruch 9, bei der die Balken (12.1, 12.2, 12.3, 12.4) an der ersten und der zweiten Seite (4.1) mit größerer Länge in einem Abstand von den Längsenden der ersten und der zweiten Seite mit größerer Länge (4.1) befestigt sind.

11. Detektionsvorrichtung nach einem der Ansprüche 1 bis 10, bei der die Balken aus einem Material hergestellt sind, das von jenem der Plattform verschieden ist.

12. Massenspektrometer, umfassend Mittel zum Ionisieren eines Analyten, Mittel zum Fokussieren des ionisierten Analyten sowie wenigstens eine Detektionsvorrichtung nach einem der Ansprüche 1 bis 11, die stromabwärts der Fokussierungsmittel angeordnet ist.

**Claims**

1. Particle detection device comprising a support and at least one moveable structure with respect to the support (2), said moveable structure comprising a platform (4), of which one face at least is intended to receive the particle(s) to detect, suspension means for suspending (6) the platform (4) such that the platform (4) can be made to vibrate with respect to the support (2), actuating means for making (8) said platform (4) vibrate at at least one of its resonance frequencies, detection means for detecting (10) the displacement of the platform (4) in a given direction, the suspension means (6) comprising at least two beams (12.1, 12.2, 12.3, 12.4), configured to deform when the platform (4) is made to vibrate, in which each beam (12.1, 12.2, 12.3, 12.4) has a length l, a width L and a thickness e and the platform (4) has a dimension in the direction of displacement of the platform, **characterized in that**

- the dimension of each beam in the given direction of displacement of the platform (4) is at least 10 times smaller than the dimension of the platform (4) in the given direction of displacement, and
- in the case of a detection device with in plane mode $l \geq 10 \times L$ and in the case of a detection device with out of plane mode $l \geq 10 \times e$,
such that, when the platform (44) is made to vibrate, said platform is not or is little deformed by the action of the beams.

2. Detection device according to claim 1, in which the suspension means (6) comprise at least one first beam and one second beam, the first and second beams being arranged symmetrically with respect to the direction of displacement.

3. Particle detection device according to claim 1 or 2, in which the actuating means (8) are external to the moveable structure.

4. Particle detection device according to claim 1 or 2, in which the actuating means (8) act directly on the platform.

5. Particle detection device according to claim 4, in which the actuating means (8) are optical means applying a gradient force at the resonance frequency to the platform or electrostatic means applying an electrostatic force at the resonance frequency to the platform.

6. Particle detection device according to one of claims 1 to 5, in which at least two beams are made of piezoresistive material, for example silicon, and in which the detection means comprise a constant voltage source (14) intended to apply a potential difference to said beams, means for measuring (16) a current at the output of said beams.

7. Particle detection device according to one of claims 1 to 6, in which the detection means comprise an optical resonator (20) arranged near to the platform (4) such that the displacement of the platform (4) modifies an evanescent field of the optical resonator (20), a waveguide (18) intended to inject a light beam into the optical resonator (20) and to collect said light beam coming out of the optical resonator (20).

8. Particle detection device according to one of claims 1 to 5 and 7, comprising several moveable structures arranged around the optical resonator, the displacement of each platform modifying the evanescent field of the optical resonator.

9. Particle detection device according to one of claims 1 to 8, in which the platform (4) is rectangular, in which two beams (12.1, 12.2) are fastened to a first side of greatest length (4.1) of the platform (4) and perpendicularly to said first side (4.1), two other beams (12.3, 12.4) are fastened to a second side of greatest length (4.1) of the platform (4) perpendicularly to said second side (4.1), and in which the beams (12.1, 12.2, 12.3, 12.4) are straight and parallel with each other.

10. Particle detection device according to claim 9, in which the beams (12.1, 12.2, 12.3, 12.4) are fastened to the first and second sides (4.1) of greatest length at a distance from the longitudinal ends of the first and second sides of greatest length (4.1).

11. Particle detection device according to one of claims 1 to 10, in which the beams are made of a material different from that of the platform.

12. Mass spectrometer comprising means for ionising an analyte, means for focusing the ionised analyte and at least one detection device according to one of claims 1 to 11 arranged downstream of the focusing means.

FIG.1

FIG.2A

FIG.3

FIG.2B

FIG.4

FIG.5A

FIG.5B

FIG.6

FIG.7

FIG.8A

FIG.8B

FIG.8C

FIG.8D

FIG.9

FIG.10

FIG.11

FIG.12A

FIG.12B

FIG.12C

FIG.13

FIG.14

FIG.15A

FIG.15B

FIG.16A

FIG.16B

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **A. RAHAFROOZ ; S. POURKAMALI.** Fabrication and characterization of thermally actuated micromechanical resonators for airborne particle mass sensing: I. Resonator design and modeling. *J. Micromechanics Microengineering,* 2010, vol. 20 (12), 125018